# EUROPÄISCHE PATENTSCHRIFT

(11) **EP 1 078 454 B1**
(45) Veröffentlichungstag und Bekanntmachung des Hinweises auf die Patenterteilung: **15.01.2003**
(21) Anmeldenummer: 99932628.3
(22) Anmeldetag: 05.05.1999
(51) Int. Cl.: H03H 9/05, H03H 3/08

(54) **PLANARE RESISTSTRUKTUR, INSBESONDERE VERKAPSELUNG FÜR ELEKTRONISCHE BAUELEMENTE UND THERMOMECHANISCHES VERFAHREN ZUR HERSTELLUNG**
PLANAR RESIST STRUCTURE, ESPECIALLY AN ENCAPSULATION FOR ELECTRIC COMPONENTS AND A THERMOMECHANICAL METHOD FOR THE PRODUCTION THEREOF
STRUCTURE DE RESIST PLANE, EN PARTICULIER ENCAPSULAGE POUR COMPOSANTS ELECTRONIQUES, ET PROCEDE THERMOMECANIQUE DE REALISATION D'UNE TELLE STRUCTURE

(30) Priorität: 05.05.1998 DE 19820049
(43) Veröffentlichungstag der Anmeldung: 28.02.2001
(73) Patentinhaber: EPCOS AG, 81541 München (DE)
(72) Erfinder: FÜRBACHER, Bruno, D-85051 Ingolstadt (DE)
(74) Vertreter: Epping, Wilhelm, Dipl.-Ing.
(86) Internationale Anmeldenummer: DE9901352
(87) Internationale Veröffentlichungsnummer: WO99057807

(56) Entgegenhaltungen:
- DE-A- 19 548 061
- US-A- 5 410 789

## Beschreibung

Die Erfindung betrifft eine planare Resiststruktur, insbesondere Verkapselung für elektronische Bauelemente und ein thermomechanisches Verfahren zum Planarisieren einer auf eine teils erhabene Trägerfläche aufgebrachten fototechnisch strukturierbaren Schicht.

Aus der US-A-5 410 789 ist ein piezoelektrischer Resonator bekannt, bei dem Elektrodenstrukturen auf dem piezoelektrischen Substrat mit einer Reaktionsharzschicht so überdeckt sind, daß die Elektrodenstrukturen in konkaven Hohlräumen in der Reaktionsharzschicht angeordnet sind.

Durch die PCT-Anmeldung, internationale Veröffentlichungsnr. WO95/30276, ist eine anmelderseits als PROTEC bezeichnete Verkapselung für elektronische Bauelemente, insbesondere für mit akustischen Oberflächenwellen arbeitende Bauelemente - OFW-Bauelemente - bekannt, die in Bereichen der Bauelemente-Strukturen, d.h. z.B. in Bereichen der Interdigitalwandler und der ggf. erforderlichen, üblicherweise in Siebdrucktechnik aufgebrachten akustischen Dämpfungsmassen diese aufnehmende Ausnehmungen besitzt. Die genannte PCT-Anmeldung sieht hierzu in einem ihrer Ausführungsbeispiele einen auf das Bauelemente-Substrat, z.B. ein piezoelektrisches Substrat, aufgebrachten rahmenförmigen Träger und ggf. Stützen vor, auf denen eine Deckschicht angeordnet ist. Der Träger, die Stützen und die Deckschicht können dabei durch eine Folie gebildet sein, die auf der Seite des Bauelemente-Substrats die Bauelemente-Strukturen überspannende Vertiefungen enthält und z.B. durch Kleben, Schweißen oder Laminieren auf das Bauelemente-Substrat aufgebracht wird.

Gemäß einem weiteren bekannten Vorschlag nach dieser PCT-Anmeldung wird für den Träger und ggf. die Stützen ein durch Fototechnik strukturierbares Material, d.h. eine sogenannte Trockenresistfolie verwendet. Dies kann beispielsweise ein Fotolack oder ein durch UV-Licht strukturierbares Material sein, das so belichtet wird, daß nach seiner Entwicklung nur die aktiven Bauelemente, insbesondere Filterstrukturen, die akustische Dämpfungsmasse und die für die elektrische Kontaktierung dieser Bauelemente-Strukturen vorgesehenen Flächen freiliegen. Sodann wird auf den so hergestellten Träger und - falls vorhanden - die Stützen eine zweite Lage, nämlich eine Abdeckschicht aufgebracht, die ebenfalls aus einer Trockenresistfolie, d.h. einem durch Fototechnik strukturierbaren Material der vorstehend genannten Art besteht, das gleichfalls nach seinem Auftrag belichtet und entwickelt wird. Dieses Material bildet schließlich bei ausreichender Dicke der aus Träger und ggf. Stützen bestehenden ersten Lage zusammen mit dieser die Ausnehmungen.

Diese auch PROTEC genannte Art der Verkapselung, die letztlich aus einem aufeinanderfolgenden und jeweils fototechnisch entsprechend behandelten Auftrag von zwei Lagen von Trockenresistfolien besteht, ist - beachte den kasten- bzw. rahmenförmigen Aufbau der ersten Lage - für alle die Fälle ungeeignet, in denen die Trockenresistfolien unmittelbar auf der akustischen Dämpfungsmasse aufliegen sollen.

Die aufgebrachte erste Lage bzw. erste Trockenresistfolie und folglich auch die zweite Lage bzw. zweite Trockenresistfolie folgen nämlich bei standardmäßigem Auflaminieren dem unebenen Höhenprofil der akustischen Dämpfungsmasse.
Der unebene Auftrag der zweiten Trockenresistfolie auf die bereits uneben aufliegende erste Trockenresistfolie ist jedoch nicht hinnehmbar, da bei den technisch sinnvollen Laminierbedingungen für die zweite Lage die resultierenden Verkapselungen, wie z.B. Abdeckungen für Chips von OFW-Bauelementen durchwegs undicht sind.

Aufgabe der vorliegenden Erfindung ist es, ein Bauelement mit einer Resiststruktur und ein Verfahren zur Herstellung dafür anzugeben, die einen sicheren Auftrag der zweiten Lage bzw. Trockenresistfolie und damit eine hermetisch dichte Verkapselung von Chips elektronischer Bauelemente, insbesondere von OFW-Bauelementen gewährleisten.

Diese Aufgabe wird mit mit einem Bauelement nach Anspruch 1 gelöst. Ein Verfahren zum Herstellen dieses Bauelements sowie vorteilhafte Ausgestaltungen der Erfindung gehen aus weiteren Ansprüchen hervor.

Erst die erfindungsgemäße planare Resiststruktur ermöglicht das konforme Aufbringen einer weiteren Schicht so, daß eine gute Verbindung zur Resiststruktur, ein sicheres Aufliegen auf dieser und in der Folge eine dichte Verkapselung erzeugt werden kann.

Vorausgesetzt die Schutzfolie, die im Verbund mit einer fotoempfindlichen Schicht die Trockenresistfolie bildet, ist eine temperaturbeständige, d.h. eine auch bei höheren Temperaturen nicht zerstörbare Folie, so sieht das erfindungsgemäße Verfahren als Lösung vor, daß die Trockenresistfolie mit ihrer fotoempfindlichen Schicht auf die Trägerfläche aufgebracht wird, daß die Trockenresistfolie unter Druck und Wärme so behandelt wird, daß ihre fotoempfindliche Schicht planarisiert wird, und daß die fotoempfindliche Schicht belichtet, anschließend die Schutzfolie entfernt und die fotoempfindliche Schicht entwickelt wird.

Wird eine nichttemperaturbeständige Schutzfolie verwendet, so sieht die Erfindung vor, daß diese nach dem Auftrag der Trokkenresistfolie von der fotoempfindlichen Schicht abgezogen und durch eine temperaturbeständige Trennfolie ersetzt wird, die auf ihrer zur fotoempfindlichen Schicht gekehrten Oberfläche eine nichthaftende Schicht trägt, daß die Trennfolie samt fotoempfindlicher Schicht unter Druck und Wärme so behandelt wird, daß ihre fotoempfindliche Schicht planarisiert wird, und daß anschließend die Trennfolie entfernt und die fotoempfindliche Schicht belichtet und entwickelt wird.

Der Auftrag bzw. das Auflaminieren der Trockenresistfolie für die erste Lage geschieht gemäß den üblichen Standardverfahren und führt zu einer luftblasenfreien Schicht, die der Topographie der z.B. in Siebdrucktechnik aufgebrachten Dämpfungsmasse folgt. Erst durch das Planarisieren, bei dem bei temperaturbeständiger Schutzfolie die Trockenresistfolie samt Träger und bei nichttemperaturbeständiger Schutzfolie der mit der fotoempfindlichen Schicht beschichtete Träger samt Trennfolie zwischen heißen Platten angeordnet und zusammengepreßt werden, verringert sich aufgrund der Temperaturerhöhung die Viskosität des fotoempfindlichen Materials der ersten Lage so weit, daß durch den axial auf den Träger ausgeübten Druck das Material dieser Lage von den Zonen, die sich über dem Siebdruck befinden, in die Zonen ohne Dämpfungsmasse fließt.

Somit wird die fotoempfindliche Schicht der ersten Lage so weit eingeebnet, daß nach anschließender Fotostrukturierung die zweite Lage Trockenresistfolie in an sich bekannter Weise auflaminiert werden kann und die resultierenden Verkapselungen, z.B. von Chips elektronischer Bauelemente, hermetisch dicht sind.

Ein Ankleben des Materials an den heißen Platten oder Preßvorrichtung wird durch die ohnehin vorhandene, ausreichende Temperaturbeständigkeit der Schutzfolie, z.B. einer Polyesterfolie, verhindert.

Weiterbildungen der Erfindung sind Gegenstand von Unteransprüchen.

Die Erfindung wird nachstehend anhand von in den Figuren der Zeichnung dargestellten Ausführungsbeispielen näher erläutert. Es zeigt:
Figur 1 bis 3 in schematischer und geschnittener Ansicht wesentliche Verfahrensschritte eines ersten Ausführungsbeispieles des Gegenstandes nach der Erfindung;
Figur 4 bis 7 in der Darstellung nach Figur 1 bis 3 die wesentlichen Verfahrensschritte eines zweiten Ausführungsbeispieles nach der Erfindung.

Gleiche Elemente in den Figuren sind dabei mit gleichen Bezugszeichen bezeichnet.

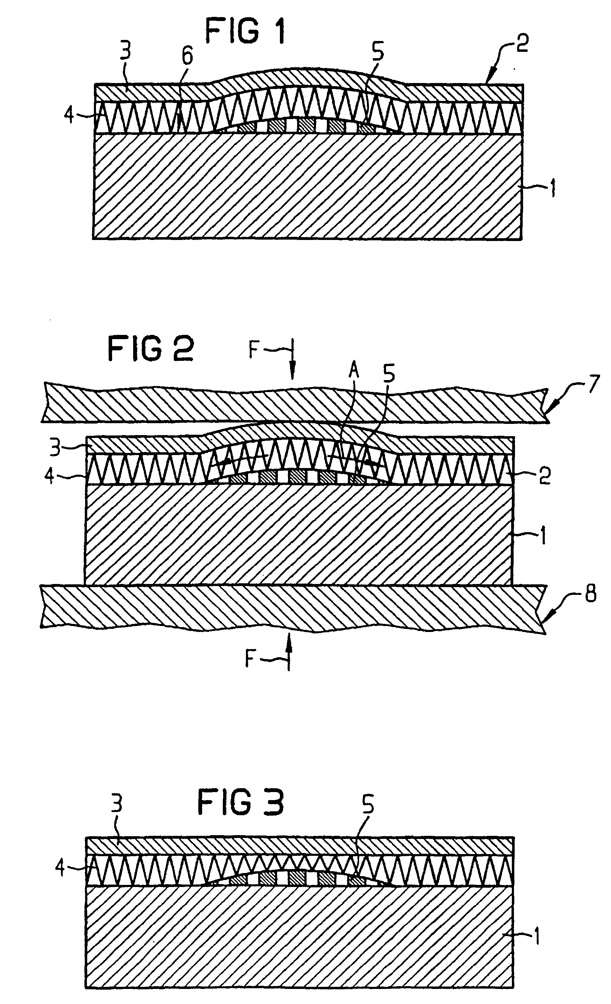

Im erstgenannten Ausführungsbeispiel, das die Herstellung eines OFW-Bauelements zeigt - s. Figur 1 bis 3 -, wird auf die eine Oberfläche 6 eines Trägers 1 aus piezoelektrischem Material, d.h. bei üblicher Massenfertigung auf einen Wafer, der in Bereichen seiner einzelnen OFW-Bauelemente jeweils z.B. in Siebdrucktechnik aufgetragene akustische Dämpfungsmassen 5 besitzt, eine Trockenresistfolie 2 in üblicher Weise auflaminiert. Die Trockenresistfolie 2 an sich besteht aus einem Verbund einer temperaturbeständigen Schutzfolie 3, z.B. einer Polyesterfolie, mit einer fotoempfindlichen Schicht 4 - s. Figur 1.

In einem weiteren Schritt - s. Figur 2 - wird der so beschichtete Wafer zwischen Heizplatten 7, 8 einer Druckvorrichtung angeordnet und die Trockenresistfolie 2 unter Druck - s. Pfeile F - und Wärme planarisiert - s. Figur 3 -, wobei das fotoempfindliche Material, betrachtet in Pfeilrichtung A, teils in die dämpfungsmassenfreien Zonen fließt.

Anschließend wird die fotoempfindliche Schicht 4 belichtet, die Schutzfolie 3 abgezogen und die.belichtete fotoempfindliche Schicht 4 entwickelt, womit der Herstellungsprozeß für die erste PROTEC-Lage abgeschlossen ist.

Als Ausgangsprodukt für die Erstellung der zur Schaffung der vollständigen Verkapselung erforderlichen zweiten PROTEC-Lage dient wiederum eine Trockenresistfolie vorstehend genannter Beschaffenheit, die mit ihrer fotoempfindlichen Schicht in an sich bekannter Weise auf die entwickelte planare Schicht 4 aufgebracht wird, wonach ihre fotoempfindliche Schicht belichtet, die Schutzfolie entfernt und die belichtete fotoempfindliche Schicht entwickelt wird.

Ersatzweise kann an Stelle vorstehend erwähnter Trockenresistfolie für die zweite PROTEC-Lage mit ihrer temperaturbeständigen Schutzfolie eine Trockenresistfolie auf die entwikkelte Schicht 4 aufgetragen werden, die eine nichttemperaturbeständige Schutzfolie, z.B. Polyolefinfolie, besitzt. In diesem Fall kann bei nicht ausreichender Durchlässigkeit für die verwendeten Wellenlängen die Belichtung der fotoempfindlichen Schicht erst nach Entfernung der Schutzfolie erfolgen.

Zur endgültigen Verkapselung werden nach dem Auftrag und Entwickein der zweiten fotoempfindlichen Schicht die entwickelten Schichten z.B. mittels UV-Strahlung und/oder thermisch ausgehärtet.

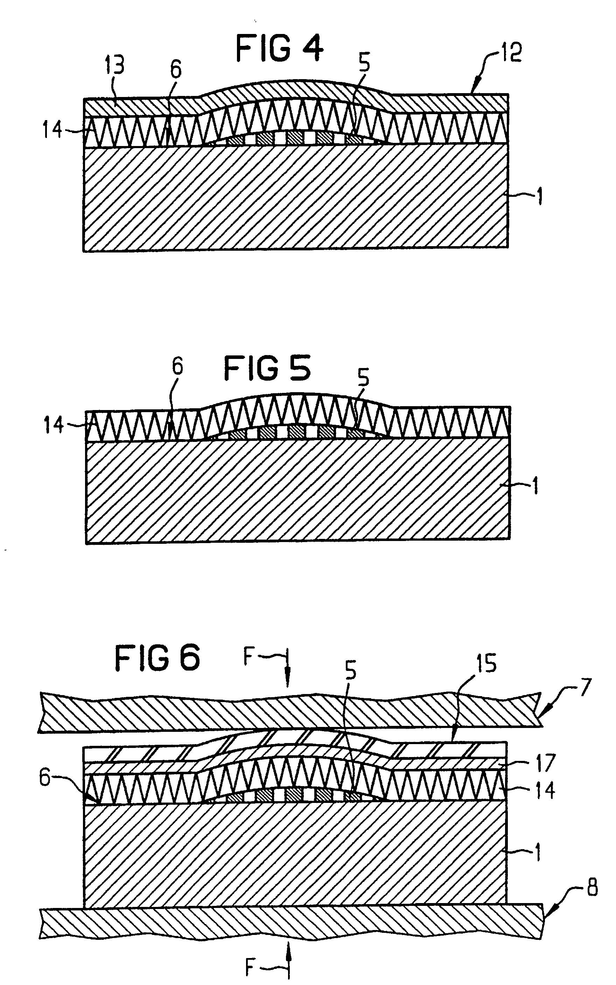

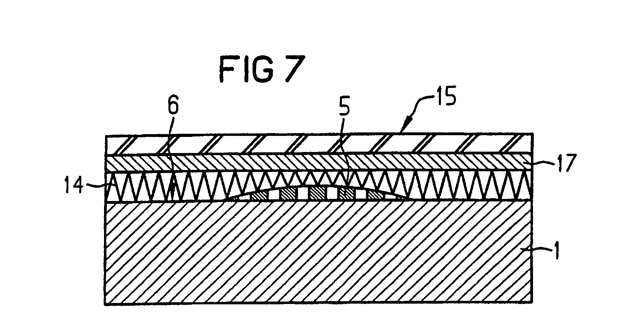

Beim Verfahren gemäß dem Ausführungsbeispiel nach Figur 4 bis 7 wird eine Trockenresistfolie 12 für die erste PROTEC-Lage verwendet, die aus einem Verbund einer nichttemperaturbeständigen Schutzfolie 13, z.B. einer Polyolefinfolie, mit einer fotoempfindlichen Schicht 14 besteht - s. Figur 4. Aufgrund ihrer nicht ausreichenden Wärmebständigkeit muß diese Schutzfolie vor dem bereits erläuterten Panarisieren entfernt - s.

Figur 5 - und durch eine temperaturbeständige Trennfolie 15, z.B. eine Polyesterfolie, ersetzt werden. Diese Trennfolie weist auf ihrer zum Träger 1 gekehrten Oberfläche z.B. eine Silikonschicht oder eine Polytetrafluorethylenschicht (PTFE-Schicht) 17 auf, die beim anschließenden Planarisieren - s. Figur 6 - das Ankleben der fotoempfindlichen Schicht 14 an der Heizplatte 7 verhindert und das spätere Entfernen der Trennfolie 15 von der fotoempfindlichen Schicht 14 ermöglicht.

Nach erfolgtem Planarisieren wird - wie bereits anhand des ersten Ausführungsbeispieles beschrieben wurde - die Trennfolie 15 entfernt und anschließend die fotoempfindliche Schicht 14 belichtet und entwickelt, womit die erste PROTEC-Lage der Verkapselung geschaffen ist.

Die zweite PROTEC-Lage wird je nach verwendeter Folie wiederum in einer der bereits beschriebenen Weisen für das erste Ausführungsbeispiel hergestellt, so daß es sich erübrigt, diese Herstellungsschritte erneut zu erläutern.

Bezugszeichenliste
- 1: - Träger
- 2: - Trockenresistfolie
- 3: - Schutzfolie
- 4: - fotoempfindliche Schicht
- 5: - Dämpfungsmasse
- 6: - Oberfläche
- 7, 8: - Heizplatten
- 12: - Trockenresistfolie
- 13: - Schutzfolie
- 14: - fotoempfindliche Schicht
- 15: - Trennfolie
- 17: - Silikonschicht, PTFE-Schicht (Teflin, Fluorpolymere)

## Patentansprüche

1. Elektronisches Bauelement
- mit auf einem Substrat (1) aufgebrachten erhabenen Strukturen (5), insbesondere mit Metallisierungen oder Leiterbahnstrukturen,
- mit einer über den erhabenen Strukturen aufgebrachten Resiststruktur (4),
- wobei die Resiststruktur dicht auf dem Substrat und den erhabenen Strukturen aufliegt und
- wobei die Resiststruktur eine derartig variierende Schichtdicke aufweist, daß die Oberfläche der Resiststruktur, die nicht auf dem Substrat und den erhabenen Strukturen aufliegt, planar ist.

2. Bauelement nach Anspruch 1,
bei dem die Resiststruktur (4) mit einer weiteren Resistschicht einheitlicher Schichtdicke abgedeckt ist.

3. Bauelement nach Anspruch 2,
- bei dem die erste Resiststruktur einen Rahmen bildet,
- bei dem die weitere Resistschicht einen auf den Rahmen passenden Deckel ausbildet
- bei dem der Rahmen und der Deckel zusammen eine kappenförmige Abdeckung darstellen und einen Hohlraum zwischen Substrat, Rahmen und Deckel umschließen.

4. Bauelement nach einem der Ansprüche 2-3,
bei dem die Resiststruktur und die weitere Resistschicht aus einer Trockenresistfolie gebildet sind.

5. Thermomechanisches Verfahren zum Erzeugen einer planaren Resiststruktur (4) auf einer Fläche eines Trägers, wobei die Fläche Erhebungen aufweist, insbesondere für eine Verkapselung elektronischer Bauelemente,
bei dem eine Trockenresistfolie (2), bestehend aus einem Verbund von temperaturbeständiger Schutzfolie (3) und fotoempfindlicher Schicht (4), mit ihrer fotoempfindlichen Schicht (4) auf die Trägerfläche (6) aufgebracht wird,
bei dem die Trockenresistfolie (2) unter Druck und Wärme so behandelt wird, daß ihre fotoempfindliche Schicht planarisiert wird, und
bei dem die fotoempfindliche Schicht (4) belichtet, anschließend die Schutzfolie (3) entfernt und die fotoempfindliche Schicht (4) entwickelt wird, wodurch die Resiststruktur erhalten wird.

6. Verfahren nach Anspruch 5,
bei dem eine Trockenresistfolie (12) mit nichttemperaturbeständiger Schutzfolie (13) verwendet wird, die nach dem Auftrag der Trockenresistfolie (12) von der fotoempfindlichen Schicht (14) abgezogen und durch eine temperaturbeständige Trennfolie (15) ersetzt wird, die auf ihrer zur fotoempfindlichen Schicht (14) gekehrten Oberfläche eine nichthaftende Schicht (17) trägt, daß die Trennfolie (15) samt fotoempfindlicher Schicht (14) unter Druck und Wärme so behandelt wird, daß ihre fotoempfindliche Schicht planarisiert wird, daß die Trennfolie (15) entfernt und anschließend die fotoempfindliche Schicht (14) belichtet und entwickelt wird.

7. Verfahren nach Anspruch 5 und 6,
bei dem auf die entwickelte fotoempfindliche Schicht (4) bzw. (14) eine zweite Trockenresistfolie, bestehend aus einem Verbund von Schutzfolie und fotoempfindlicher Schicht, mit ihrer fotoempfindlichen Schicht auf die entwickelte Schicht (4) bzw. (14) aufgebracht, anschließend die fotoempfindliche Schicht belichtet, danach die Schutzfolie entfernt und die fotoempfindliche Schicht entwickelt wird.

8. Verfahren nach Anspruch 5 und 6,
bei dem auf die entwickelte fotoempfindliche Schicht (4) bzw. (14) eine zweite Trockenresistfolie, bestehend aus einem Verbund von Schutzfolie und fotoempfindlicher Schicht, mit ihrer fotoempfindlichen Schicht auf die entwickelte Schicht aufgebracht, anschließend die Schutzfolie abgezogen, danach belichtet und entwickelt wird.

9. Verfahren nach Anspruch 5 bis 8,
bei dem nach dem Auftrag und Entwickeln der zweiten fotoempfindlichen Schicht die entwickelten Schichten ausgehärtet werden.

10. Verfahren nach Anspruch 5,
bei dem die Trockenresistfolie (2) samt Träger (1) zwischen heißen Platten (7, 8) angeordnet und zusammengepreßt wird.

11. Verfahren nach Anspruch 6,
bei dem der mit der fotoempfindlichen Schicht (14) beschichtete Träger (1) samt Trennfolie (15) zwischen heißen Platten (18, 19) angeordnet und zusammengepreßt wird.

12. Verfahren nach einem der Ansprüche 5 bis 11,
bei dem als temperaturbeständige Schutz- und Trennfolie (2) bzw. (15) eine Polyesterfolie verwendet wird.

13. Verfahren nach einem der Ansprüche 6 - 12
bei dem als nichttemperaturbeständige Schutzfolie (12) z.B. eine Polyolefinfolie verwendet wird.

14. Verfahren nach Anspruch 12,
bei dem eine Trennfolie (15) verwendet wird, die auf ihrer zur fotoempfindlichen Schicht (14) gekehrten Oberfläche mit einer dem Kleben entgegenwirkenden Schicht, z.B. mit einer Silikon- oder PTFE-Schicht, (17) beschichtet ist.

15. Verwendung des Verfahren nach Anspruch 5 bis 14,
zur Herstellung von Oberflächenwellen-Bauelementen mit Wafern als Träger.

## Claims

1. Electronic component
- having elevated structures (5) applied on a substrate (1), in particular having metallization layers or interconnect structures,
- having a resist structure (4) applied above the elevated structures,
- the resist structure bearing tightly on the substrate and the elevated structures, and
- the resist structure having a varying layer thickness such that the surfaces of the resist structure which does not bear on the substrate and elevated structures is planar.

2. Component as claimed in Claim 1,
in which the resist structure (4) is covered with a further resist layer of uniform layer thickness.

3. Component as claimed in Claim 2,
- in which the first resist structure forms a frame,
- in which the further resist layer forms a cover matching the frame,
- in which the frame and the cover together constitute a cap-like covering and enclose a cavity between substrate, frame and cover.

4. Component as claimed in one of Claims 2-3,
in which the resist structure and the further resist layer are formed from a dry resist sheet.

5. Thermomechanical process for producing a planar resist structure (4) on an area of a carrier, the area having elevations, in particular for an encapsulation of electronic components,
in which a dry resist sheet (2), comprising a composite of temperature-resistant protective sheet (3) and photosensitive layer (4), is applied by its photosensitive layer (4) to the carrier area (6),
in which the dry resist sheet (2) is treated under pressure and with heat in such a way that its photosensitive layer is planarized, and
in which the photosensitive layer (4) is exposed, then the protective sheet (3) is removed and the photosensitive layer (4) is developed, the resist structure thereby being obtained.

6. Process as claimed in Claim 5,
in which use is made of a dry resist sheet (12) having a non-temperature-resistant protective sheet (13), which, after the application of the dry resist sheet (12), is drawn off from the photosensitive layer (14) and replaced by a temperature-resistant separating sheet (15), which carries a non-adhering layer (17) on its surface directed towards the photosensitive layer (14), in that the separating sheet (15) together with the photosensitive layer (14) is treated under pressure and with heat in such a way that its photosensitive layer is planarized, in that the separating sheet (15) is removed and then the photosensitive layer (14) is exposed and developed.

7. Process as claimed in Claims 5 and 6,
in which a second dry resist sheet, comprising a composite of protective sheet and photosensitive layer, is applied by its photosensitive layer to the developed photosensitive layer (4) or (14) to the developed layer (4) or (14) [sic], then the photosensitive layer is exposed, after which the protective sheet is removed and the photosensitive layer is developed.

8. Process as claimed in Claims 5 and 6,
in which a second dry resist sheet, comprising a composite of protective sheet and photosensitive layer, is applied by its photosensitive layer to the developed photosensitive layer (4) or (14) to the developed layer, then the protective sheet is drawn off, after which exposure and development are effected.

9. Process as claimed in Claims 5 to 8,
in which, after the application and development of the second photosensitive layer, the developed layers are cured.

10. Process as claimed in Claim 5,
in which the dry resist sheet (2) together with the carrier (1) is arranged between hot plates (7, 8) and compressed.

11. Process as claimed in Claim 6,
in which the carrier (1) coated with the photosensitive layer (14), together with the separating sheet (15), is arranged between hot plates (18, 19) and compressed.

12. Process as claimed in one of Claims 5 to 11,
in which a polyester sheet is used as the temperature-resistant protective and separating sheet (2) and (15), respectively.

13. Process as claimed in one of Claims 6-12,
in which a polyolefin sheet, for example, is used as the non-temperature-resistant protective sheet (12).

14. Process as claimed in Claim 12,
in which a separating sheet (15) is used which is coated with a layer that counteracts adhesive bonding, e.g. with a silicone or PTFE layer, (17) on its surface directed towards the photosensitive layer (14).

15. Use of the process as claimed in Claim 5 to 14,
for producing surface acoustic wave components with wafers as carriers.

## Revendications

1. Composant électronique
• ayant des structures (5) proéminentes appliquées sur un substrat (1), en particulier des métallisations ou des structures de pistes conductrices,
• avec une structure de résist (4) appliquée sur les structures proéminentes,
• la structure de résist reposant étroitement sur le substrat et sur les structures proéminentes et
• la structure de résist présentant une épaisseur de couche variable de telle sorte que la surface de la structure de résist qui ne repose pas sur le substrat et sur les structures proéminentes est plane.

2. Composant selon la revendication 1 pour lequel la structure de résist (4) est recouverte d'une autre couche de résist d'une épaisseur de couche uniforme.

3. Composant selon la revendication 2,
• pour lequel la première structure de résist forme un cadre,
• pour lequel la couche de résist suivante forme un couvercle ajusté sur le cadre,
• pour lequel le cadre et le couvercle représentent ensemble un revêtement en forme de capot et entourent un espace creux entre le substrat, le cadre et le couvercle.

4. Composant selon l'une des revendications 2-3 pour lequel la structure de résist et les autres couches de résist sont formées par un film de résist sec.

5. Procédé thermomécanique pour produire une structure de résist (4) plane sur une surface d'un support, la surface présentant des proéminences, en particulier pour l'encapsulage de composants électroniques,
pour lequel un film de résist sec (2), consistant en un composé de film de protection (3) résistant à la température et en une couche (4) photosensible, est appliqué par sa couche (4) photosensible sur le film de résist sec (6),
pour lequel le film de résist sec (2) est traité sous pression et à la chaleur de sorte que sa couche photosensible est aplanie et
pour lequel la couche (4) photosensible est exposée, puis le film de protection (3) est retiré et la couche (4) photosensible est développée, ce qui permet d'obtenir la structure de résist.

6. Procédé selon la revendication 5 pour lequel on utilise un film de résist sec (12) ayant un film de protection (13) non résistant à la température qui est retiré de la couche (14) photosensible après l'application du film de résist sec (12) et est remplacé par un film de séparation (15) résistant à la température qui porte une couche (17) non adhésive sur sa surface tournée vers la couche (14) photosensible, de sorte que le film de séparation (15) avec la couche (14) photosensible est traité sous pression et à la chaleur de telle manière que sa couche photosensible est aplanie, que le film de séparation (15) est retiré et ensuite la couche (14) photosensible est exposée et développée.

7. Procédé selon les revendications 5 et 6 pour lequel, sur la couche (4) ou (14) photosensible développée, un deuxième film de résist sec composé d'un composé de film de protection et de couche photosensible est appliqué avec sa couche photosensible sur la couche (4) ou (14) développée, ensuite la couche photosensible est exposée, puis le film de protection est retiré et la couche photosensible est développée.

8. Procédé selon la revendication 5 et 6 pour lequel sur la couche (4) ou (14) photosensible développée, un deuxième film de résist sec, consistant en un composé de film de protection et en une couche photosensible, est appliqué avec sa couche photosensible sur la couche développée, ensuite le film de protection est retiré, puis il est exposé et développé.

9. Procédé selon la revendication 5 à 8 pour lequel les couches développées sont durcies après l'application et le développement de la deuxième couche photosensible.

10. Procédé selon la revendication 5 pour lequel le film de résist sec (2) avec le support (1) sont placés entre des plaques chaudes (7, 8) et l'un est pressé contre l'autre.

11. Procédé selon la revendication 6 pour lequel le support (1) recouvert de la couche (14) photosensible avec le film de séparation (15) sont placés entre des plaques chaudes (7, 8) et l'un est pressé contre l'autre.

12. Procédé selon l'une des revendications 5 à 11 pour lequel on utilise un film en polyester en tant que film de protection et que film de séparation (2) ou (15) résistant à la température.

13. Procédé selon l'une des revendications 6 à 12 pour lequel on utilise par exemple un film en polyoléfine. en tant que film de protection (12) non résistant à la température

14. Procédé selon la revendication 12 pour lequel on utilise un film de séparation (15) qui est recouvert sur sa surface tournée vers la couche (14) photosensible d'une couche agissant contre l'adhérence, par exemple d'une couche en silicone ou en PTFE (17).

15. Utilisation du procédé selon les revendications 5 à 14 pour fabriquer des composants ondes acoustiques de surface avec des plaquettes en tant que support.
